Europäisches Patentamt

European Patent Office

Office européen des brevets

(11) Publication number: **0 208 548 B1**

## EUROPEAN PATENT SPECIFICATION

(45) Date of publication of patent specification: **10.03.93**　(51) Int. Cl.5: **H01P 1/218**, H01F 10/24

(21) Application number: **86305294.0**

(22) Date of filing: **09.07.86**

(54) YIG thin film microwave apparatus.

(30) Priority: **09.07.85 JP 150430/85**
**28.02.86 JP 43206/86**

(43) Date of publication of application:
**14.01.87 Bulletin 87/03**

(45) Publication of the grant of the patent:
**10.03.93 Bulletin 93/10**

(84) Designated Contracting States:
**DE FR GB NL**

(56) References cited:
**EP-A- 0 057 614**
**EP-A- 0 157 216**
**EP-A- 0 164 685**
**US-A- 4 269 651**

**1985 IEEE-MTT-S INTERNATIONAL MICRO-WAVE SYMPOSIUM DIGEST, Saint-Louis, Missouri, 4th-6th June 1985, pages 285-288, IEEE, New York, US; Y. MURAKAMI et al.: "A bandpass filter using YIG film grown by LPE"**

(73) Proprietor: **SONY CORPORATION**
**7-35 Kitashinagawa 6-chome Shinagawa-ku Tokyo 141(JP)**

(72) Inventor: **Murakami, Yoshikazu c/o Pat. Div.**

Sony Corp.
6-7-35 Kitashinagawa
Shinagawa-ku Tokyo 141(JP)
Inventor: **Tanaka, Hideo c/o Pat. Div. Sony Corp.**
6-7-35 Kitashinagawa
Shinagawa-ku Tokyo 141(JP)
Inventor: **Miyake, Masami c/o Pat. Div. Sony Corp.**
6-7-35 Kitashinagawa
Shinagawa-ku Tokyo 141(JP)
Inventor: **Ito, Seigo c/o Pat. Div. Sony Corp.**
6-7-35 Kitashinagawa
Shinagawa-ku Tokyo 141(JP)
Inventor: **Tamada, Hitoshi c/o Pat. Div. Sony Corp.**
6-7-35 Kitashinagawa
Shinagawa-ku Tokyo 141(JP)
Inventor: **Yamada, Toshiro c/o Pat. Div. Sony Corp.**
6-7-35 Kitashinagawa
Shinagawa-ku Tokyo 141(JP)

(74) Representative: **Pilch, Adam John Michael et al**
**D. YOUNG & CO. 10 Staple Inn**
**London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.5x/3.0.1)

## Description

This invention relates to YIG (Yttrium Iron Garnet) thin film microwave apparatus, and in particular to such apparatus including a YIG thin film device utilising the ferrimagnetic resonance effect.

There has been proposed microwave apparatus, such as a microwave filter or a microwave oscillator, which utilises the ferrimagnetic resonance of a YIG thin film as a ferrimagnetic material formed on a GGG (Gadolinium Gallium Garnet) non-magnetic substrate by means of liquid-phase epitaxial growth (which will be hereinafter referred to as LPE) and worked into a desired shape, such as a circular or rectangular shape, by selective etching with a photolithographic technique. The microwave apparatus makes it possible to form a microwave integrated circuit with a transmission line such as a micro-strip line, and easily effect hybrid connection with another microwave integrated circuit. Furthermore, since microwave apparatus utilising magnetic resonance of the YIG thin film may be prepared by the LPE and the photolithography techniques as mentioned above, mass productivity can readily be achieved. Such microwave apparatus has been proposed in 1985 IEEE-MIT-S INTERNATIONAL MICROWAVE SYMPOSIUM DIGEST, saint Louis, Missouri, 4-6 June 1985, pages 285 - 288, IEEE, New York, USA, Y. MURAKAMI et.al: "A bandpass filter using YIG film grown by LPE.

For the above reasons, microwave apparatus utilising the magnetic resonance of the YIG thin film has practical advantages over conventional magnetic resonance devices using a YIG sphere.

However, in microwave apparatus utilising ferrimagnetic resonance of the YIG thin film, the ferrimagnetic resonance frequency f of the YIG thin film is largely dependent upon the temperature T. Therefore, there arises a significant problem in practical use, namely that the temperature characteristics are not satisfactory.

Such a problem will now be described. The ferrimagnetic resonance frequency f of the YIG thin film may be expressed in the following manner by using Kittel's equation, provided that an anisotropic field contribution to the resonance frequency is small enough to be neglected.

$$f(T) = \gamma\{Hg\ (T) - Nz^Y 4\pi Ms^Y(T)\} \qquad (1)$$

where $\gamma$ is the gyromagnetic ratio ($\gamma$ = 2.8 MHz/Oe or 35 KHz/A/m); Hg is the D.C. bias magnetic field; $Nz^Y$ is the demagnetisation factor of the YIG thin film, which factor is calculated by using a magnetostatic mode theory; and $4\pi Ms^Y$ is the saturation magnetisation of the YIG film. All of f, Hg and $4\pi Ms^Y$ are functions of the temperature T. In one example of perpendicular resonance of a YIG disc having an aspect ratio (thickness/diameter) of 0.01, the demagnetisation factor $Nz^Y$ is 0.9774, and the saturation magnetisation $4\pi Ms^Y$ is 1916 G (Gauss) (0.1916T) at -20°C, and 1622 G (0.1622T) at +60°C, supposing that the bias magnetic field Hg is constant irrespective of temperature. Accordingly, the resonance frequency f can vary by 835 MHz in the temperature range of -20°C to +60°C.

In order to avoid deviation in the resonance frequency due to environmental temperature in the YIG thin film microwave apparatus, there has been proposed a method for maintaining the YIG thin film magnetic resonance device at a constant temperature by placing the device in a thermostatic chamber, or alternatively a method for maintaining the resonance frequency of the device constant by changing a magnetic field in dependence on temperature by means of an electromagnet. However, these methods necessitate an external energy supply means such as a current controller, thereby making construction complicated.

According to the present invention there is provided YIG thin film microwave apparatus comprising a YIG thin film device utilising the ferrimagnetic resonance effect, and a magnetic circuit having a gap of length $\ell g$ in which said YIG thin film device is disposed and applying a bias magnetic field perpendicular to a film surface of said YIG thin film device, said magnetic circuit including a permanent magnet having a thickness $\ell m$ end a soft magnetic plate having a thickness $\ell x$, characterised by said permanent magnet satisfying the characteristics:

$$Br^o > (fo/\gamma) + Nz^Y 4\pi Mso^Y$$

$$\alpha_1^B > \frac{Nz^Y 4\pi Mso^Y}{(fo/\gamma) + Nz^Y 4\pi Mso^Y} \cdot \alpha_1^Y$$

and said soft magnetic plate satisfying the characteristics:

$$4\pi Mso^X < (fo/\gamma) + Nz^Y 4\pi Mso^Y$$

$$\alpha_1^X < \frac{Nz^Y 4\pi Mso^Y}{(fo/\gamma) + Nz^Y 4\pi Mso^Y} \cdot \alpha_1^Y$$

wherein: fo is the resonance frequency of said YIG thin film device;
$\gamma$ is the gyromagnetic ratio of said YIG thin film;
$Nz^Y$ is the demagnetisation factor of said YIG thin film;
$4\pi Mso^Y$ is the saturation magnetisation of said YIG thin film at room temperature;
$4\pi Mso^X$ is the saturation magnetisation of said soft magnetic plate;
$Br^o$ is the remanence of said permanent magnet at room temperature;
$\alpha_1^B$ is the first order temperature coefficient of the remanence of said permanent magnet at or near room temperature;
$\alpha_1^Y$ is the first order temperature coefficient of the saturation magnetisation of said YIG thin film at or near room temperature;
$\alpha_1^X$ is the first order temperature coefficient of the saturation magnetisation of said soft magnetic plate at or near room temperature;
and wherein said thicknesses $\ell$m and $\ell$x are selected to improve the temperature characteristics of the resonance frequency of the apparatus.

A preferred embodiment of the present invention provides a YIG thin film microwave apparatus which does not require an external circuit for compensating for the temperature characteristics, thereby involving no further power consumption for compensating for the temperature characteristics. The apparatus is capable of carrying out compensation of the temperature characteristics over a wide frequency range.

The preferred YIG thin film microwave apparatus may be used either at a fixed frequency or at a variable frequency.

According to another embodiment of the present invention there is provided a microwave apparatus of the above construction in which the YIG thin film is formed of substituted YIG material, where the trivalent iron ion $Fe^{3+}$ in the YIG is partially substituted with a non-magnetic ion. Thus temperature compensation can be achieved by selecting the thickness of the permanent magnet $\ell$m, the thickness of the soft magnetic plate $\ell$x and the substituted amount $\delta$ expressed as a formula unit.

The invention will now be described by way of example with reference to the accompanying drawings, throughout which like parts are referred to by like references, and in which:

Figures 1, 4 and 5 are schematic views of YIG thin film microwave apparatus according to respective embodiments of the present invention;

Figure 2 is a graph illustrating the temperature characteristics of the saturation magnetisation of Mg-Mn-Al ferrite;

Figures 3 and 6 are graphs illustrating the temperature characteristics against resonance frequency in a preferred embodiment of the microwave apparatus of the present invention;

Figure 7 is a graph illustrating the temperature characteristics against the saturation magnetisation of the YIG; and

Figure 8 is a graph illustrating the relationship between a Ga substituted quantity in the YIG and a variation $\Delta$f in the resonance frequency.

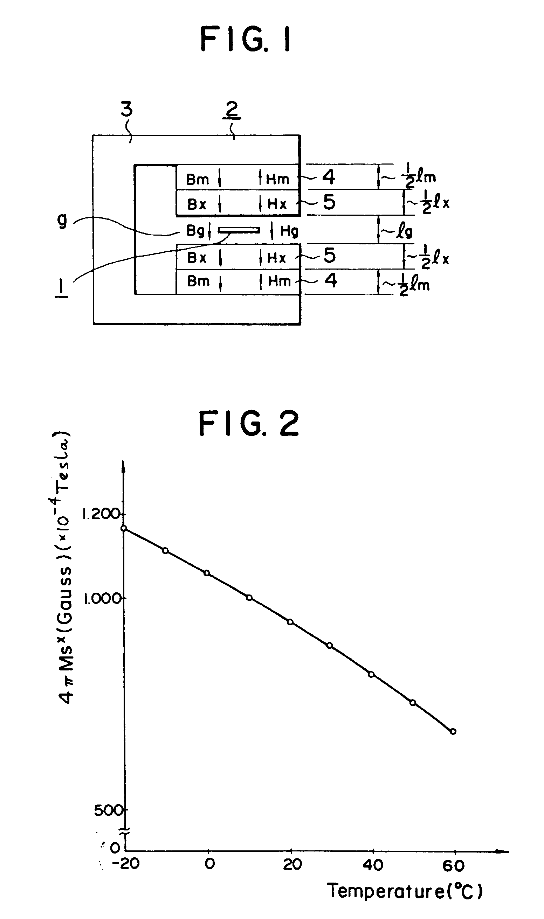

Referring to Figure 1 which shows a YIG thin film microwave apparatus according to one embodiment of the present invention, a YIG thin film microwave device 1 includes strip lines (not shown) electromagnetically coupled to the YIG thin film, and a magnetic circuit 2 is arranged to apply a bias magnetic field to the microwave device 1. In one example, the magnetic circuit 2 comprises a U-shaped yoke 3, permanent magnets 4 each having a thickness $\ell$m and soft magnetic plates 5, for example made of soft ferrite, and each having a thickness $\ell$x. The permanent magnets 4 and the soft magnetic plates 5 are arranged on opposed surfaces at both end portions of the yoke 3 to define a magnetic gap g having a spacing of $\ell$g between the soft magnetic plates 5. The microwave device 1 is located in the magnetic gap g.

In the magnetic circuit shown in Figure 1, supposing that all the magnetic flux passes through the magnetic gap g, the magnetic field in the gap g is uniform, and the permeability of the yoke is infinite, the following equations are derived from Maxwell's equations.

Bm = Bx = Bg     (2)

$\ell$mHm = $\ell$gHg + $\ell$xHx     (3)

Where, Bm, Bx and Bg are the magnetic flux densities in the permanent magnet 4, the soft magnetic plate 5 and the magnetic gap g, respectively; and Hm, Hx and Hg are the magnetic fields in the permanent magnet 4, the soft magnetic plate 5 and the magnetic gap g, respectively, the direction of Hm being opposite to that of Hg, Hx, Bm, Bx and Bg.

Supposing that the permanent magnet 4 does not have a knee point, and the recoil permeability of the permanent magnet 4 is constant, that is its demagnetisation curve shows linearity, the following Equation (4) is satisfied.

Hm = $\frac{1}{\mu r}$ (Br -Bm) = $\frac{1}{\mu r}$ Br - Hg     (4)

Supposing that the soft magnetic (ferrite) plate 5 is sufficiently saturated, and its saturation magnetisation and demagnetisation factors are $4\pi Ms^X$ and $Nz^X$, respectively, the magnetic field Hx in the soft ferrite plate is expressed by the following Equation (5).

Hx = Hg - $Nz^X 4\pi Ms^X$     (5)

Supposing that a change in the dimensions of the magnetic circuit due to thermal expansion is sufficiently small, and may be neglected, the magnetic field Hg in the gap of the magnetic circuit 2 is derived from Equations (3), (4) and (5) to give the following Equation (6) as a function of the temperature T.

$$Hg(T) = \frac{(\ell m Br(T)/\mu r) + \ell x Nz^X 4\pi Ms^X(T)}{\ell g + (\ell m/\mu r) + \ell x} \quad \ldots\ldots\ldots (6)$$

In consideration of the temperature coefficients $\alpha_1^B$, $\alpha_2^B$, $\alpha_1^Y$, $\alpha_2^Y$, $\alpha_1^X$ and $\alpha_2^X$ to the second order of the magnet, YIG and soft ferrite plate in a temperature range of $\pm$ several tens of $^\circ$C about room temperature To, more specifically $\pm 40C^\circ$, the remanence Br of the permanent magnet and the saturation magnetisation $4\pi Ms^Y$ of the YIG may be expressed with a sufficient accuracy as follows:

Br(T) = $Br^o\{1 + \alpha_1^B(T-To) + \alpha_2^B(T-To)^2\}$     (7)

$4\pi Ms^Y(T)$ = $4\pi Mso^Y\{1 + a_1^Y (T-To) + a_2^Y(T-To)^2\}$     (8)

$4\pi Ms^X(T)$ = $4\pi Mso^X\{1 + \alpha_1^X(T-To) + \alpha_2^X(T-To)^2\}$     (9)

To make the resonance frequency f(T) into a constant value independent of the temperature T, it is necessary to derive the following Equation (10) from Equations (1) and (6).

$$\frac{(\ell m Br(T)/\mu r) + \ell x Nz^X 4\pi Ms^X(T)}{\ell g + (\ell m/\mu r) + \ell x} = (fo/\gamma) + Nz^Y 4\pi Ms^Y(T)$$
$$\ldots\ldots\ldots\ldots (10)$$

Substituting Equations (7), (8) and (9) into Equation (10), and equating each term of the Oth, 1st and 2nd orders with respect to the temperature T, the following equations can be obtained.

$(\ell m Br^o/\mu r) + \ell x N2^X 4\pi Mso^X = \{\ell g + (\ell m/\mu r/) + \ell x\} \{(fo/\gamma) + Nz^Y 4\pi Mso^Y\}$     (11)

$(\ell m Br^o \alpha_1^B/\mu r) + \ell x N2^X 4\pi Mso^X \alpha_1^X = \{\ell g + (\ell m/\mu r) + \ell x\} Nz^Y 4\pi Mso^Y \alpha_1^Y$     (12)

$(\ell m Br^o \alpha_2^B/\mu r) + \ell x N2^X 4\pi Mso^X \alpha_2^X = \{\ell g + (\ell m/\mu r) + \ell x\} Nz^Y 4\pi Mso^Y \alpha_2^Y$     (13)

Assuming that each material for the YIG, permanent magnet and soft magnetic plate is given, and the spacing $\ell g$ of the magnetic gap is also given, it is impossible to obtain the combination of $\ell m$ and $\ell x$ simultaneously satisfying Equations (11), (12) and (13).

Accordingly, the coefficients of the 0th order and the 1st order are equalised as primary terms. Namely, the values $\ell m$ and $\ell x$ satisfying Equations (11) and (12) are given as follows:

EP 0 208 548 B1

$$\ell m = \cfrac{\mu r \ell g N z^{X} 4\pi Mso^{X} \left\{ \cfrac{\alpha_1{}^{X}}{N z^{Y} 4\pi Mso^{Y} \alpha_1{}^{Y}} \; - \; \cfrac{1}{(fo/\gamma) + N z^{Y} 4\pi Mso^{Y}} \right\}}{\left\{ \cfrac{Br^{O}}{(fo/\gamma) + N z^{Y} 4\pi Mso^{Y}} - 1 \right\} \left\{ \cfrac{N z^{X} 4\pi Mso^{X} \alpha_1{}^{X}}{N z^{Y} 4\pi Mso^{Y} \alpha_1{}^{Y}} - 1 \right\} - \left\{ \cfrac{N z^{X} 4\pi Mso^{Y}}{(fo/\gamma) + N z^{Y} 4\pi Mso^{Y}} - 1 \right\} \left\{ \cfrac{Br^{O} \alpha_1{}^{B}}{N z^{Y} 4\pi Mso^{Y} \alpha_1{}^{Y}} - 1 \right\}}$$

$$\dotfill (14)$$

$$\ell x = \frac{Br^0}{(fo/\gamma)+Nz^Y4\pi Mso^Y}\left\{\frac{Nz^X4\pi Mso^X\alpha_1^X}{Nz^Y4\pi Mso^Y\alpha_1^Y}\right\}^{-1} - \ell gBr^0\left(\frac{\alpha_1^B}{Nz^Y4\pi Mso^Y\alpha_1^Y} - \frac{1}{(fo/\gamma)+Nz^Y4\pi Mso^Y}\right)\left\{\frac{Nz^X4\pi Mso^Y}{(fo/\gamma)+Nz^Y4\pi Mso^Y}\right\}^{-1}\left\{\frac{Br^0\alpha_1^B}{Nz^Y4\pi Mso^Y\alpha_1^Y}\right\}^{-1}\cdots\cdots\cdots\cdots\cdots \quad (15)$$

It is appreciated from Equations (14) and (15) that the following conditions must be established so as to let $\ell m$ and $\ell x$ have a positive solution.

$$Br^0 > (fo/\gamma) + Nz^Y4\pi Mso^Y \quad (16)$$

7

$$Nz^x 4\pi Mso^x < (fo/\gamma) + Nz^Y 4\pi Mso^Y \qquad (17)$$

$$\alpha_1^B > \frac{-Nz^Y 4\pi Mso^Y}{(fo/\gamma) + Nz^Y 4\pi Mso^Y} \cdot \alpha_1^Y \qquad \dots\dots\dots\dots\dots\dots (18)$$

$$\alpha_1^x < \frac{Nz^Y 4\pi Mso^Y}{(fo/\gamma) + Nz^Y 4\pi Mso^Y} \cdot \alpha_1^Y \qquad \dots\dots\dots\dots\dots\dots (19)$$

Since $Nz \lesssim 1$ in Expression (17), it is appreciated that Expression (17) always holds if the following condition is established.

$$4\pi Mso^x < (fo/\gamma) + Nz^Y 4\pi Mso^Y \qquad (20)$$

Accordingly, good temperature characteristics may be achieved by combining a permanent magnet material having a remanence Br at room temperature greater than $(fo/\gamma) + Nz^Y 4\pi Mso^Y$ and a 1st order temperature coefficient $\alpha_1^B$ of the remanence Br near the room temperature greater than $Nz^Y 4\pi Mso^Y \cdot \alpha_1^Y / \{-(fo/\gamma) + Nz^Y 4\pi Mso^Y\}$, with a so-called soft magnetic plate having a saturation magnetisation $4\pi Mso^Y$ at room temperature smaller than $(fo/\gamma) + Nz^Y 4\pi Mso^Y$ and a 1st order temperature coefficient $\alpha_1^X$ of the saturation magnetisation $4\pi Ms^X$ near the room temperature smaller than $Nz^Y 4\pi Mso^Y \cdot \alpha_1^Y / \{(fo/\gamma) + Nz^Y 4\pi Mso^Y\}$.

In the structure shown in Figure 1, the soft magnetic plate 5 is formed of Mg-Mn-Al ferrite having temperature characteristics as shown in Figure 2, and the permanent magnet 4 is formed of any one of: $Nd_2 Fe_{14} B$ magnet having $Br = 11000$ G, $\alpha_1^B = -1.2 \times 10^{-3}$ and $\alpha_2^B = -0.75 \times 10^{-6}$, $CeCO_5$ magnet having $Br = 6000$ G, $\alpha_1^B = -0.9 \times 10^{-3}$ and $\alpha_2^B = 0$, and $SmCo_5$ magnet having $Br = 8500$ G, $a_1^B = -0.5 \times 10^{-3}$ and $\alpha_2^B = 0$.

The thicknesses $\ell x$ and $\ell m$ and frequency deviation $\Delta f$ in consideration of the 2nd order coefficient in the temperature range of -20°C to +60°C are as shown in Table I, Table II and Table III.

Table I    Table showing centre frequency
           of YIG and variation thereof

| fo (GHz) | $\ell m$ (mm) | $\ell x$ (mm) | $\Delta f$ (MHz) |
|----------|---------------|---------------|------------------|
| 1.0      | 0.885         | 1.089         | +-5.82           |
| 2.0      | 1.013         | 0.609         | +-3.97           |
| 3.0      | 1.124         | 0.195         | +-2.12           |
| 4.0      |               | <0            |                  |

$Br = 10000G$    $\alpha_2{}^B = 7.5 \times 10^{-7}$

$\alpha_1{}^B = 1.20 \times 10^{-3}$    $\mu r = 1.05$

Table II    Table showing centre frequency
            of YIG and variation thereof

| fo (GHz) | $\ell m$ (mm) | $\ell x$ (mm) | $\Delta f$ (MHz) |
|----------|---------------|---------------|------------------|
| 1.0      | 2.401         | 2.646         | +-5.88           |
| 2.0      | 3.020         | 2.190         | +-4.04           |
| 3.0      | 3.665         | 1.715         | +-2.21           |
| 4.0      | 4.335         | 1.222         | +-0.37           |
| 5.0      | 5.034         | 0.707         | +-1.46           |
| 6.0      | 5.762         | 0.171         | +-3.29           |
| 7.0      |               | <0            |                  |

$Br = 6000G$    $\alpha_2{}^B = 0$

$\alpha_1{}^B = -9.00 \times 10^{-4}$    $\mu r = 1.01$

Table III — Table showing centre frequency of YIG and variation thereof

| fo (GHz) | $\ell m$ (mm) | $\ell x$ (mm) | $\Delta f$ (MHz) |
|---|---|---|---|
| 1.0 | 1.701 | 3.956 | +-9.66 |
| 2.0 | 2.183 | 3.826 | +-8.71 |
| 3.0 | 2.706 | 3.685 | +-7.76 |
| 4.0 | 3.274 | 3.532 | +-6.81 |
| 5.0 | 3.894 | 3.365 | +-5.86 |
| 6.0 | 4.574 | 3.182 | +-4.91 |
| 7.0 | 5.323 | 2.980 | +-3.96 |
| 8.0 | 6.151 | 2.757 | +-3.01 |
| 9.0 | 7.071 | 2.510 | +-2.06 |
| 10.0 | 8.101 | 2.232 | +-1.11 |
| 11.0 | 9.261 | 1.920 | +-0.16 |
| 12.0 | 10.576 | 1.566 | +-0.79 |
| 13.0 | 12.082 | 1.160 | +-1.74 |
| 14.0 | 13.822 | 0.692 | +-2.69 |
| 15.0 | 15.856 | 0.144 | +-3.64 |
| 16.0 | | <0 | |

$$Br = 8500G \qquad \alpha_2^B = 0$$

$$\alpha_1^B = -5.00 \times 10^{-4} \qquad \mu r = 1.01$$

In the above, the gap spacing $\ell g$ was set to 3mm, and $4\pi Mso^X = 943.8$ G (0.09438 T), $\alpha_1^X = -6.38 \times 10^{-3}$ and $\alpha_2^X = -1.40 \times 10^{-5}$ were set in view of Figure 2. In this case, it is appreciated that the conditions of Expressions (20) and (18) always hold irrespective of the frequency fo. Furthermore, as is apparent from Tables I to III, the realisable frequency fo has a certain range according to the kind of permanent magnet used.

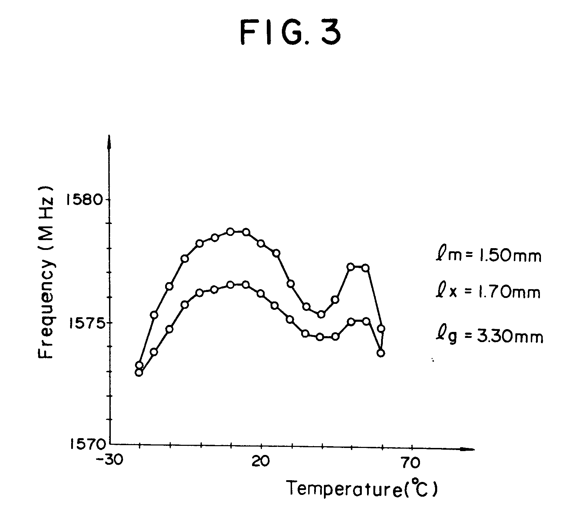

Figure 3 shows temperature characteristics against the resonance frequency of YIG in the case that the magnetic circuit 2 is formed by the combination of the Mg-Mn-Al soft ferrite plate 5 and the $Nd_2Fe_{14}B$ magnet 4. As is apparent from Figure 3, the frequency variation $\Delta f$ falls within a range of ±2.9 MHz with respect to a centre frequency of 1.575 GHz in the temperature range of -20°C to + 60°C.

Although the magnetic circuit 2 is constituted of one kind of permanent magnet 4 and one kind of soft ferrite plate 5 in the aforementioned embodiment, two kinds of magnet and one kind of soft ferrite plate may instead be combined to form the magnetic circuit.

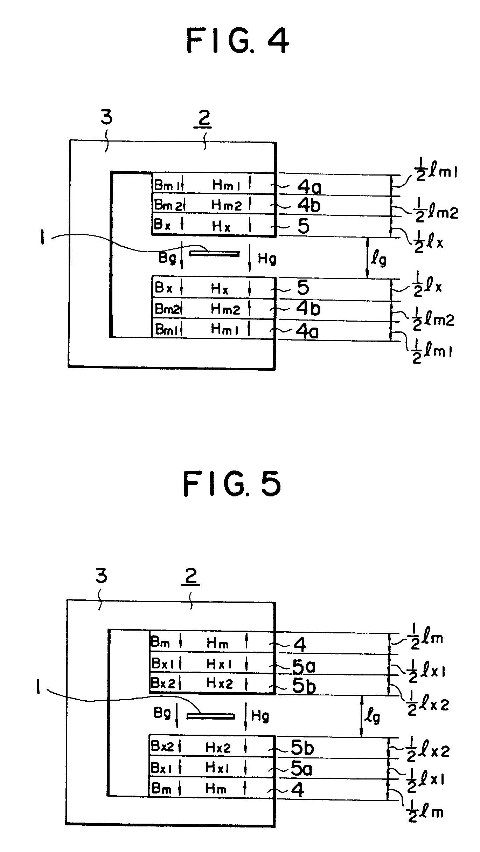

Figure 4 shows a magnetic circuit 2 formed by combining two kinds of permanent magnet 4a and 4b with the soft ferrite plate 5. In this case, the following equation (21) corresponding to Equation (6) is derived.

$$Hg(T) = \frac{(\ell m_1 Br_1(T)/\mu r_1) + (\ell m_2 Br_2(T)/\mu r_2) + (\ell x N z^x 4\pi M s^x(T))}{\ell g + (\ell m_1/\mu r_1) + (\ell m_2/\mu r_2) + \ell x} \quad \cdots\cdots\cdots\cdots (21)$$

Where, $Br_1$ and $Br_2$ are the remanences of the permanent magnets 4a and 4b, respectively; $\mu r_1$ and $\mu r_2$ are the recoil permeabilities of the permanent magnets 4a and 4b, respectively; and $\ell m_1$ and $\ell m_2$ are the total thicknesses of the permanent magnets 4a and 4b, respectively.

Representing the sum of the respective thicknesses of the permanent magnets 4a and 4b by $\ell m^t$, the following equation can be obtained.

$$\ell m^t = \ell m_1 + \ell m_2 \quad (22)$$

Representing an average recoil permeability of the whole of the permanent magnets 4a and 4b by $\widetilde{\mu}r$, $\ell m^t/\widetilde{\mu}r = (\ell m_1/\mu r_1) + (\ell m_2/\mu r_2)$ is given, and the following equation is derived therefrom.

$$\widetilde{\mu r} = \frac{\ell m^t}{(\ell m_1/\mu r) + (\ell m_2/\mu r_2)}$$

$$= \frac{\ell m_1 + \ell m_2}{(\ell m_1/\mu r_1) + (\ell m_2/\mu r_2)}$$

$$\widetilde{\mu r} = \frac{(\ell m_1 + \ell m_2)\mu r_1 \mu r_2}{\ell m_1 \mu r_2 + \ell m_2 \mu r_1} \quad \cdots\cdots\cdots\cdots\cdots (23)$$

Representing an average remanence of the permanent magnets 4a and 4b by Br(T), the following equation can be obtained.

$$\ell m^t \widetilde{Br}(T)/\widetilde{\mu r} = (\ell m_1 Br_1(T)/\mu r) + (\ell m_2 Br_2(T)/\mu r_2)$$

$$\widetilde{Br}(T) = \frac{(\ell m_1 Br_1(T)/\mu r_1) + (\ell m_2 Br_2(T)/\mu r_2)}{\ell m^t/\widetilde{\mu r}}$$

$$= \frac{(\ell m_1/\mu r_1)Br_1(T) + (\ell m_2/\mu r_2)Br_2(T)}{(\ell m_1/\mu r_1) + (\ell m_2/\mu r_2)} \quad \cdots\cdots\cdots (24)$$

Substituting the following equations into Equation (24),

$$\widetilde{Br}(T) = \widetilde{Br}^o\{1 + \widetilde{\alpha}_1{}^B(T-T_o) + \widetilde{\alpha}_2{}^B(T-T_o)^2\}$$

$$Br_1(T) = Br_1{}^o\{1 + \alpha_1{}^B{}_1(T-T_o) + \alpha_2 B_1(T-T_o)^2\}$$
$$Br_2(T) = Br_2{}^o\{1 + \alpha_1{}^B{}_2(T-T_o) + \alpha_2{}^B{}_2(T-T_o)^2\}$$

and comparing each term of the 0th, 1st and 2nd orders with respect to the temperature on both sides, the following equations can be obtained.

$$\widetilde{Br}^O = \frac{(\ell m_1/\mu r_1)\cdot Br_1{}^O + (\ell m_2/\mu r_2)\cdot Br_2{}^O}{(\ell m_1/\mu r_1) + (\ell m_2/\mu r_2)}$$

$$\widetilde{\alpha}_1{}^B = \frac{(\ell m_1 Br_1{}^O/\mu r_1)\cdot \alpha_1{}^B 1 + (\ell m_2 Br_2{}^O/\mu r_2)\cdot \alpha_1{}^B 2}{(\ell m_1 Br_1{}^O/\mu r_1) + (\ell m_2 Br_2{}^O/\mu r_2)}$$

$$\widetilde{\alpha}_2{}^B = \frac{(\ell m_1 Br_1{}^O/\mu r_1)\cdot \alpha_2{}^B 1 + (\ell m_2 Br_2{}^O/\mu r_2)\cdot \alpha_2{}^B 2}{(\ell m_1 Br_1{}^O/\mu r_1) + (\ell m_2 Br_2{}^O/\mu r_2)}$$

$$\dots\dots\dots\dots\dots\dots (25)$$

Representing a ratio of the thickness of the permanent magnets 4a and 4b by $a = \ell m_1/\ell m_2$, a ratio of the recoil permeabilities of the permanent magnets 4a and 4b by $b = \mu r_1/\mu r_2$, and a ratio of the remanences of the permanent magnets 4a and 4b at room temperature by $c = Br_1{}^O/Br_2{}^O$, Equation (25) can be expressed as follows:

$$\widetilde{Br}^O = \frac{(a/b)\cdot Br_1{}^O + Br_2{}^O}{(a/b) + 1}$$

$$\widetilde{\alpha}_1{}^B = \frac{(ac/b)\cdot \alpha_1{}^B 1 + \alpha_1{}^B 2}{(ac/b) + 1}$$

$$\widetilde{\alpha}_2{}^B = \frac{(ac/b)\cdot \alpha_2{}^B 1 + \alpha_2{}^B 2}{(ac/b) + 1} \qquad\qquad \dots\dots\dots\dots\dots (26)$$

Defining each parameter as mentioned above, Equation (21) can be expressed in the same form as Equation (6) as follows:

$$Hg(T) = \frac{(\ell m^t \widetilde{Br}(T)/\widetilde{\mu r}) + (\ell x N z^x 4\pi Ms^x(T)}{(\ell g + \ell m^t) + (\widetilde{\mu r} + \ell x)} \quad \dots\dots\dots\dots (27)$$

Deriving from Equation (27), the following Expressions (28) and (29) corresponding to Expressions (16) and (18) can be obtained.

$$\widetilde{Br}^o > (fo/\gamma) + Nz^Y 4\pi Mso^Y \qquad \dots\dots\dots\dots\dots\dots (28)$$

$$\widetilde{\alpha}_1^B > \frac{Nz^Y 4\pi Mso^Y}{(fo/\gamma) + Nz^Y 4\pi Mso^Y} \cdot \alpha_1^Y \qquad \dots\dots\dots\dots\dots\dots (29)$$

In summary, provided that the ratios a, b and c are defined by a = $\ell m_1/\ell m_2$, b = $\mu r_1/\mu r_2$, and c = $Br_1^o/Br_2^o$, respectively, good temperature characteristics may be achieved by combining the permanent magnets 4a and 4b having the average remanence $\widetilde{Br}^o$ at room temperature satisfying Equation (28) and the 1st order temperature coefficient $\widetilde{\alpha}_1^B$ of the average remanence satisfying Equation (29), $\widetilde{Br}^o$ and $\widetilde{\alpha}_1^B$ being defined by Equation (26), with the soft ferrite plate having the saturation magnetisation $4\pi Mso^X$ at room temperature smaller than $(fo/\gamma) + Nz^Y 4\pi Mso^Y$ and the 1st order temperature coefficient $\alpha_1^X$ of the saturation magnetisation $4\pi Mso^X$ near the room temperature smaller than $Nz^Y 4\pi Mso^Y \cdot \alpha_1^Y / \{(fo/\gamma) + Nz^Y 4\pi Mso^Y\}$.

As is mentioned above, the use of the soft ferrite plate in combination with the two kinds of permanent magnets 4a and 4b is more advantageous than the case of using only two kinds of permanent magnets 4a and 4b.

In the case that two kinds of permanent magnets only are used, the remanence Br of the permanent magnets varies to a relatively significant extent, and it is difficult to cut the magnets after being magnetised. Therefore, it is necessary to adjust the gap spacing finally, so as to let the resonance frequency of the YIG thin film accord with a required frequency. However, if the gap spacing $\ell g$ is different from the set value, the temperature characteristics are disadvantageously changed.

On the other hand, in the case that a soft ferrite plate is used in combination with the permanent magnets, the temperature characteristics are so adjusted as to accord substantially with an objective or required value by the soft ferrite plate, while the slippage or variation of the temperature characteristics generated by the adjustment of the gap spacing due to variation in the remanence of the permanent magnets may be finally finely adjusted by the soft ferrite plate. Namely, the resonance frequency and the temperature characteristics may be simultaneously brought into accordance with the require or objective value.

Figure 5 shows a magnetic circuit 2 using one kind of permanent magnet 4 and two kinds of first and second soft ferrite plates 5a and 5b formed of different materials.

In this case, the following Equation (30) corresponding to Equation (6) can be derived.

$$Hg(T) = \frac{(\ell mBr(T)/\mu r) + \ell x_1 Nz^{X1} 4\pi Ms^{X1}(T)\, \ell x_2 Nz^{X2} 4\pi Ms^{X2}(T)}{\ell g + (\ell m/\mu r) + \ell x_1 + \ell x_2}$$

$$\dots\dots\dots\dots\dots\dots (30)$$

Where $4\pi Ms^{X1}$ and $4\pi Ms^{X2}$ are saturation magnetisations of the first and second soft ferrite plates 5a and 5b, respectively; $Nz^{X1}$ and $Nz^{X2}$ are demagnetisation factors of the soft ferrite plates 5a and 5b, respectively; and $\ell x_1$ and $\ell x_2$ are total thicknesses of the soft ferrite plates 5a and 5b, respectively.

Representing the sum of respective thicknesses of the soft ferrite plates 5a and 5b by $\ell x^t$, the following equation can be derived.

$$\ell x^t = \ell x_1 + \ell x_2 \qquad (31)$$

Representing an average demagnetisation of the soft ferrite plates 5a and 5b by $\widetilde{Nz}^X$ and an average saturation magnetisation of the soft ferrite plates 5a and 5b by $4\pi Ms^X(T)$, the following equation can be drived.

$$\ell x \cdot \widetilde{Nz}^X \cdot \widetilde{4\pi Ms}^X (T) = \ell x_1 Nz^{X1} 4\pi Ms^{X1}(T) + \ell x_2 Nz^{X2} 4\pi Ms^{X2}(T)$$

Therefore, the following equation is obtained.

$$\widetilde{Nz}^X \cdot \widetilde{4\pi Ms}^X (T) = \frac{\ell x_1 Nz^{X1} 4\pi Ms^{X1}(T) + \ell x_2 Nz^{X2} 4\pi Ms^{X2}(T)}{\ell x_1 + \ell x_2} \quad \cdots \cdots \cdots (32)$$

Substituting the following equations into Equation (32),

$$\widetilde{4\pi Ms}^X (T) = \widetilde{4\pi Mso}^X \{1 + \alpha_1^X (T-To) + \widetilde{\alpha_2}^X (T-To)^2\}$$

$$4\pi Ms^{X1}(T) = 4\pi Mso^{X1}\{1 + \alpha_1^{X1} (T-To) + \alpha_2^{X1} (T-To)^2\}$$

$$4\pi Ms^{X2}(T) = 4\pi Mso^{X2}\{1 + \alpha_1^{X2} (T-To) + \alpha_2^{X2} (T-To)^2\}$$

and comparing each term of the 0th, 1st and 2nd orders with respect to the temperature on both sides, the following equations can be obtained.

$$\widetilde{Nz}^Y \cdot \widetilde{4\pi Mso}^X = \frac{\ell x_1 Nz^{X1} 4\pi Mso^{X1} + \ell x_2 Nz^{X2} 4\pi Mso^{X2}}{\ell x_1 + \ell x_2}$$

$$\widetilde{\alpha_1}^X = \frac{\ell x_1 Nz^{X1} 4\pi Mso^{X1} \cdot \alpha_1^{X1} + \ell x_2 Nz^{X2} 4\pi Mso^{X2} \cdot \alpha_1^{X2}}{\ell x_1 Nz^{X1} 4\pi Mso^{X1} + \ell x_2 Nz^{X2} 4\pi Mso^{X2}}$$

$$\widetilde{\alpha_2}^X = \frac{\ell x_1 Nz^{X1} 4\pi Mso^{X1} \cdot \alpha_2^{X1} + \ell x_2 Nz^{X2} 4\pi Mso^{X2} \cdot \alpha_2^{X2}}{\ell x_1 Nz^{X1} 4\pi Mso^{X1} + \ell x_2 Nz^{X2} 4\pi Mso^{X2}} \quad \cdots \cdots \cdots (33)$$

Representing a ratio of the thicknesses of the soft ferrite plates 5a and 5b by $a = \ell x_1 / \ell x_2$, a ratio of the demagnetisation factors of the soft ferritc plates 5a and 5b by $b = Nz^{X1}/Nz^{X2}$ and a ratio of the saturation magnetisations of the soft ferrite plates 5a and 5b at room temperature by $c = 4\pi Mso^{X1}/4\pi Mso^{X2}$, Equation (33) can be also expressed as follows:

14

$$\widetilde{Nz}^X \cdot \widetilde{4\pi Mso}^X = \frac{aNz^{X1}4\pi Mso^{X1} + Nz^{X2}4\pi Mso^{X2}}{a + 1}$$

$$\widetilde{\alpha_1}^X = \frac{abc \cdot \alpha_1^{X1} + \alpha_1^{X2}}{abc + 1}$$

$$\widetilde{\alpha_2}^X = \frac{abc \cdot \alpha_2^{X1} + \alpha_2^{X2}}{abc + 1} \qquad \dots\dots\dots\dots\dots\dots (34)$$

Defining each parameter as mentioned above, Equation (34) can be expressed in the same form as Equation (6) as follows:

$$Hg(T) = \frac{(\ell m Br(T)/\mu r) = \ell x^t \widetilde{Nz}^X \ \widetilde{4\pi Ms}^X(T)}{\ell g + (\ell m/\mu r) + \ell x^t}$$

$$\dots\dots\dots\dots\dots\dots (35)$$

Deriving from Equation (35), the following Expressions (36) and (37) corresponding to Expressions (17) and (18) can be obtained.

$$\widetilde{Nz}^X \cdot \widetilde{4\pi Mso}^X < fo/\gamma + Nz^Y 4\pi Mso^Y \qquad \dots\dots\dots\dots\dots\dots (36)$$

$$\widetilde{\alpha_1}^X < \frac{Nz^Y 4\pi Mso^Y}{fo/\gamma + Nz^Y 4\pi Mso^Y} \cdot \alpha_1^Y \qquad \dots\dots\dots\dots\dots\dots (37)$$

In summary, provided that the ratios a, b and c are defined by $a = \ell x_1/\ell x_2$, $b = Nz^{X1}/Nz^{X2}$, and $c = 4\pi Mso^{X1}/4\pi Mso^{X2}$, respectively, good temperature characteristics may be achieved by combining a soft ferrite plate having the product $\widetilde{Nz}^X \cdot \widetilde{4\pi Mso}^X$ of the average demagnetisation factor and the average saturation magnetisation factor and the average saturation magnetisation at room temperature, which product satisfies Equation (38), and the 1st order temperature coefficient $\alpha_1^X$ of the average saturation magnetisation satisfying Equation (37), with the permanent magnet 4 under the aforementioned conditions, which has the remanence Br at room temperature greater than $(fo/\gamma) + Nz^Y 4\pi Mso^Y$ and the 1st order temperature coefficient $\alpha_1^B$ of the remanence Br near the room temperature greater than

$Nz^Y 4\pi Mso^Y \cdot \alpha_1^Y / \{(fo/\gamma) + Nz^Y 4\pi Mso^Y\}$.

Although the present invention has been described as applied to a microwave apparatus using a fixed frequency in the above embodiment, it may be applied to a variable type YIG thin film microwave apparatus including a coil (not shown) wound around the yoke 3 in the magnetic circuit 2.

As is described above, a gradient in the temperature characteristics of the resonance frequency can be nullified by determining $\ell m$ and $\ell x$ satisfying Equations (11) and (12). However, a curvature of the temperature characteristics cannot be compensated by these conditions only. That is to say, as shown in

15

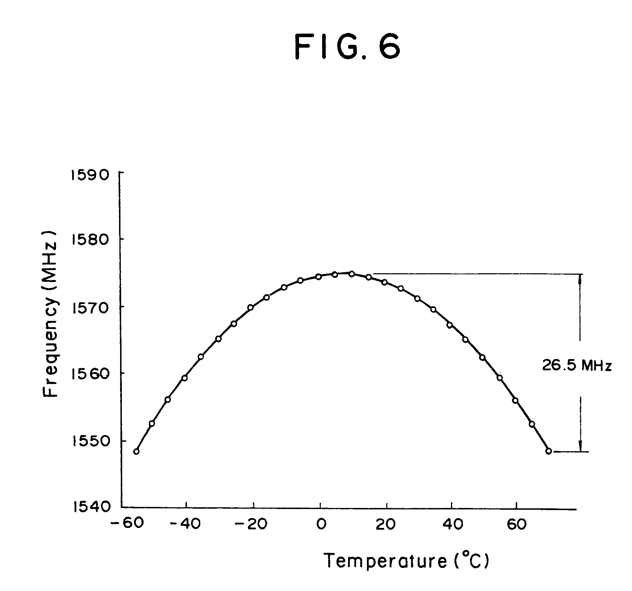

Figure 1, the magnetic circuit of the YIG thin film microwave apparatus having a centre frequency of 1.575 GHz is formed by using Mg-Mn-Al ferrite having the temperature characteristics shown in Figure 2 as the soft magnetic plate 5 and $Nd_2Fe_{14}B$ magnet as the permanent magnet 4. As to variation in the centre frequency in the temperature range of -55°C to +70°C, the microwave apparatus shows temperature characteristics having an upper convex curve with a variation range of 25.5 MHz as shown in Figure 6. This is due to the fact that it is necessary to make a compensated part of the temperature characteristics by the ferrite large as the centre frequency of the microwave device is lowered, resulting in that the upper convex curve exhibited by the ferrite is largely reflected on the temperature characteristics of the YIG thin film microwave apparatus. The microwave device 1 is constituted of a substitution type YIG, and accordingly the compensated part of the temperature characteristics by the ferrite may be reduced to nullify the upper convex curvature when a substituted quantity $\delta$ is zero. In other words, three unknown quantities consisting of the substituted quantity $\delta$ of the substitution type YIG, the thickness $\ell m$ of the permanent magnet and the thickness $\ell x$ of the soft ferrite plate may be determined so as to simultaneously satisfy Equations (11), (12) and (13), and accordingly the curvature of the temperature characteristics as well as the gradient may be nullfied. If materials of the permanent magnet and the ferrite, the shape of the YIG thin film, the resonance frequency and the gap spacing are previously given, $Br^o$, $\alpha_1{}^B$, $\alpha_2{}^B$, $\mu r$, $4\pi Mso^X$, $\alpha_1{}^X$, $\alpha_2{}^X$, $Nz^Y$, $fo/\gamma$, and $\ell g$ are constants as predetermined. $Nz^Y$ is not an independent variable since it is determined by the thickness $\ell x$ of the ferrite. Further, if the substituted quantity $\delta$ of a non-magnetic ion for $Fe^{3+}$ ion in the YIG is determined, $4\pi Mso^Y$, $\alpha_1{}^Y$ and $\alpha_2{}^Y$ are also determined. After all, the independent unknown quantities comprise $\delta$, $\ell m$ and $\ell x$. Accordingly, if the three unknown quantities $\delta$, $\ell m$ and $\ell x$ are determined from Equations (11), (12) and (13), these are the conditions for obtaining a fixed resonance frequency fo in consideration of the temperature characteristics to the 2nd order. That is to say, if the substitution type YIG thin film microwave device is used, and the substituted quantity $\delta$ is selected, the curvature of the temperature characteristics may be also compensated.

In connection with the arrangement shown in Figure 1, the microwave device 1 is formed by a substitution type YIG thin film, for example a thin film formed by substituting a trivalent non-magnetic ion such as $Ga^{3+}$ and $Al^{3+}$ for a part of $Fe^{3+}$ of the YIG, or by combining divalent and tetravalent non-magnetic ions $Ca^{2+}$ and $Ge^{4+}$ to equivalently substitute a trivalent ion for $Fe^{3+}$ of the YIG.

A change in saturation magnetisation of the substitution type YIG, that is, a change in saturation magnetisation due to substitution of the non-magnetic ion for $Fe^{3+}$ ion of the YIG will now be investigated. Firstly, the change compared to a pure single crystal of YIG will be investigated. In the pure single crystal of YIG ($Y_3Fe_5O_{12}$), three $Fe^{3+}$ ions are located at the tetrahedral site, and two $Fe^{3+}$ ions are located at the octahedral site. The $Fe^{3+}$ ions at the tetrahedral site and the $Fe^{3+}$ ions at the octahedral site are arranged in antiparallel relation with each other by strong negative superexchange interaction. As a result, the saturation magnetisation of YIG is depedent on a magnetic moment of 5 Bohr magneton ($5\mu B$) owned by one $Fe^{3+}$ ion remaining as the result of balance of the five $Fe^{3+}$ ions in the antiparallel arrangement. In the case that a trivalent ion, for example $Ga^{3+}$, is substituted for a part of the $Fe^{3+}$ ions of the pure YIG, all of the trivalent ion will be substituted for the $Fe^{3+}$ ions at the tetrahedrel site if the substituted quantity $\delta$ is not so large. Therefore, the magnetic moment in one molecule is given as follows:

$$5\mu_B \times \{(3-\delta)-2\} = 5(1-\delta)\mu_B$$

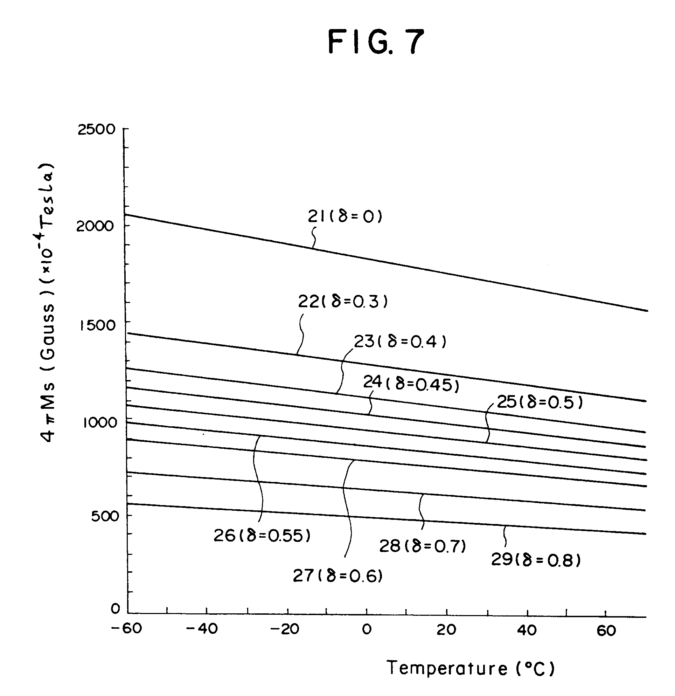

Accordingly, the saturation magnetisation is reduced. The saturation magnetisation of Ga substituted YIG is reported in J. of Applied Physics Vol. 45, No. 6, 6, 1974, p.2728 - 2730. Using Equations (1) to (4) in this literature, and examining a change in the saturation magnetisation with respect to temperature when the Ga substituted quantity is changed, there may be obtained the characteristics as shown in Figure 7. Referring to Figure 7, the curved lines (21) to (29) correspond to the substituted quantities $\delta$ = 0, 0.3, 0.4, 0.45, 0.5, 0.55, 0.6, 0.7 and 0.8, respectively. Further, there are shown in Table IV calculated values of the saturation magnetisation $4\pi Mso^Y$ at a central temperature of 7.5°C and the 1st and 2nd order temperature coefficient $\alpha_1{}^Y$ and $\alpha_2{}^Y$ at - 55°C to +70°C with respect to each of the Ga substituted quantities $\delta$, which values are obtained by a method of least squares.

Table IV  Table showing calculated values of saturation magnetisation and temp. coefficients with respect to Ga substituted quantity

$Y_3Fe_5 - \delta Ga\delta O_{12}$

Temp:  $-55°C \sim +70°C$

| $\delta$ | $4\pi Ms$ (Gauss) | $\alpha_1^Y$ | $\alpha_2^Y$ |
|---|---|---|---|
| 0 | 1817.3 | $-1.9984 \times 10^{-3}$ | $-9.1474 \times 10^{-7}$ |
| 0.3 | 1277.1 | $-2.1336 \times 10^{-3}$ | $-1.6778 \times 10^{-6}$ |
| 0.4 | 1107.9 | $-2.1731 \times 10^{-3}$ | $-2.0601 \times 10^{-6}$ |
| 0.45 | 1025.7 | $-2.1902 \times 10^{-3}$ | $-2.2898 \times 10^{-6}$ |
| 0.5 | 945.2 | $-2.2047 \times 10^{-3}$ | $-2.5498 \times 10^{-6}$ |
| 0.55 | 866.4 | $-2.2157 \times 10^{-3}$ | $-2.8497 \times 10^{-6}$ |
| 0.6 | 789.4 | $-2.2219 \times 10^{-3}$ | $-3.1946 \times 10^{-6}$ |
| 0.7 | 641.0 | $-2.2121 \times 10^{-3}$ | $-4.0739 \times 10^{-6}$ |
| 0.8 | 500.7 | $-2.1510 \times 10^{-3}$ | $-5.3324 \times 10^{-6}$ |

Then, the soft magnetic plate 5 shown in Figure 1 is formed by Mg-Mn-Al ferrite having the temperature characteristics shown in Figure 2, and the permanent magnet 4 is formed by one of $Md_2Fe_{14}B$, $CeCO_5$ and $5mCo_5$ to thereby form a YIG thin film filter having a centre frequency of 1.575 GHz. In this connection, there are shown in Table V calculated values of a necessary thickness $\ell m$ of the permanent magnet, a necesary thickness $\ell x$ of the ferrite, and the frequency variation $\Delta f$ at - 55°C to + 70°C.

Table V

fo = 1.575 GHz

$Y_3Fe_{5-\delta}Ga_\delta O_{12}$

Table showing calculated values of each thickness $\ell m$, $\ell x$ and frequency variation $\Delta f$ with respect to Ga substituted quantity

| $Nd_2Fe_{14}B$ magnet used | | | |
|---|---|---|---|
| $\delta$ | $\ell m$ (mm) | $\ell x$ (mm) | $\Delta f$ (MHz) |
| 0.00 | 1.071 | 0.981 | 26.52 |
| 0.30 | 0.713 | 0.564 | 9.16 |
| 0.40 | 0.619 | 0.426 | 2.94 |
| 0.45 | 0.577 | 0.358 | 0.27 |
| 0.50 | 0.538 | 0.291 | 3.49 |
| 0.55 | 0.501 | 0.224 | 6.78 |
| 0.60 | 0.467 | 0.158 | 10.08 |
| 0.70 | 0.406 | 0.028 | 16.77 |

| $CeCo_5$ magnet used | | | |
|---|---|---|---|
| $\delta$ | $\ell m$ (mm) | $\ell x$ (mm) | $\Delta f$ (MHz) |
| 0.00 | 2.704 | 2.349 | 23.02 |
| 0.30 | 1.498 | 1.182 | 6.41 |
| 0.40 | 1.248 | 0.903 | 0.41 |
| 0.45 | 1.141 | 0.777 | 2.69 |
| 0.50 | 1.045 | 0.659 | 5.81 |
| 0.55 | 0.959 | 0.547 | 8.99 |
| 0.60 | 0.880 | 0.442 | 12.20 |
| 0.70 | 0.746 | 0.248 | 18.71 |

| $SmCo_5$ magnet used | | | |
|---|---|---|---|
| $\delta$ | $\ell m$ (mm) | $\ell x$ (mm) | $\Delta f$ (MHz) |
| 0.00 | 1.957 | 3.989 | 44.29 |
| 0.30 | 1.032 | 1.978 | 23.11 |
| 0.40 | 0.851 | 1.546 | 15.74 |
| 0.45 | 0.775 | 1.357 | 12.00 |
| 0.50 | 0.708 | 1.183 | 8.25 |
| 0.55 | 0.647 | 1.023 | 4.47 |
| 0.60 | 0.592 | 0.874 | 0.69 |
| 0.70 | 0.499 | 0.606 | 6.89 |

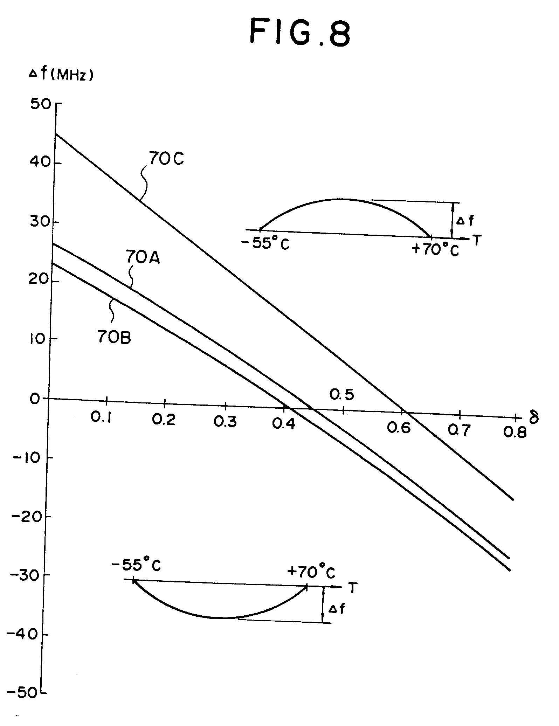

A change in the frequency variation $\Delta f$ with respect to the Ga substituted quantity $\delta$ is plotted in Figure 8. Referring to Figure 8, curved lines (70A), (70B) and (70C) correspond to the cases of using $Nd_2Fe_{14}B$ magnet, $CeCo_5$ magnet and $SmCo_5$ magnet, respectively. In all the cases, $\Delta f$ is positive at $\delta = 0$, and the temperature characteristics show an upper convex curvature. Further, $\Delta f$ is decreased with a decrease in $\delta$. As $\delta$ is further decreased, $\Delta f$ becomes negative, and the temperature characteristics show a lower convex curvature. Thus, it is appreciated that the temperature characteristics of $\Delta f = 0$ is obtained by selecting the value of $\delta$. In other words, it is possible to nullify a gradient and curvature of the temperature characteristics of the resonance frequency of YIG by selecting a substituted quantity of a non-magnetic ion for the $Fe^{3+}$ ion in the YIG thin film of the microwave device according to the materials of the permanent magnet and the soft magnetic plate.

Although the present invention has been described as applied to a microwave apparatus using a fixed frequency in the above embodiment, it may be applied to a variable type YIG thin film microwave apparatus including a coil (not shown) wound around the yoke 3 in the magnetic circuit 2.

As has been described above, microwave apparatus having good temperature characteristics may be provided by employing a permanent magnet and a soft magnetic plate each having respective specific characteristics in a magnetic circuit for applying a bias magnetic field to a microwave device which utilises the magnetic resonance of the YIG thin film.

Furthermore, since it is possible to provide microwave apparatus having good temperature characteristics where both gradient and curvature of the temperature characteristics are compensated for, the extent of utilisation of the microwave apparatus may be enlarged to increase the industrial advantage by effectively employing the YIG thin film feature of the microwave apparatus, which is superior in terms of mass production, as previously mentioned.

## Claims

1. YIG thin film microwave apparatus comprising a YIG thin film device (1) utilising the ferrimagnetic resonance effect, and a magnetic circuit (2) having a gap of length $\ell g$ in which said YIG thin film device (1) is disposed and applying a bias magnetic field perpendicular to a film surface of said YIG thin film device (1), said magnetic circuit (2) including a permanent magnet (4) having a thickness $\ell m$ and a soft magnetic plate (5) having a thickness $\ell x$, characterised by said permanent magnet (4) satisfying the characteristics:

$$Br^o > (fo/\gamma) + Nz^Y 4\pi Mso^Y$$

$$\alpha_1^B > \frac{Nz^Y 4\pi Mso^Y}{(fo/\gamma) + Nz^Y 4\pi Mso^Y} \cdot \alpha_1^Y$$

and said soft magnetic plate (5) satisfying the characteristics:

$$4\pi Mso^X < (fo/\gamma) + Nz^Y 4\pi Mso^Y$$

$$\alpha_1^X < \frac{Nz^Y 4\pi Mso^Y}{(fo/\gamma) + Nz^Y 4\pi Mso^Y} \cdot \alpha_1^Y$$

wherein: fo is the resonance frequency of said YIG thin film device (1);
$\gamma$ is the gyromagnetic ratio of said YIG thin film;
$Nz^Y$ is the demagnetisation factor of said YIG thin film;
$4\pi Mso^Y$ is the saturation magnetisation of said YIG thin film at room temperature;
$4\pi Mso^X$ is the saturation magnetisation of said soft magnetic plate (5);
$Br^o$ is the remanence of said permanent magnet (4) at room temperature;
$\alpha_1^B$ is the first order temperature coefficient of the remanence of said permanent magnet (4) at or near room temperature;
$\alpha_1^Y$ is the first order temperature coefficient of the saturation magnetisation of said YIG thin film at or near room temperature;
$\alpha_1^X$ is the first order temperature coefficient of the saturation magnetisation of said soft magnetic plate (5) at or near room temperature;
and wherein said thicknesses $\ell m$ and $\ell x$ are selected to improve the temperature characteristics of the resonance frequency of the apparatus.

**2.** YIG thin film microwave apparatus according to claim 1, wherein said YIG thin film device (1) is formed of a substituted YIG thin film in which part of the $Fe^{3+}$ ion content is substituted by an amount $\delta$ of a non-magnetic element, the amount $\delta$ being expressed as a formula unit, and wherein, in addition to said thicknesses $\ell m$ and $\ell x$, the amount $\delta$ is selected to improve the temperature characteristics of the resonance frequency of the apparatus.

**Patentansprüche**

**1.** Mikrowellenvorrichtung mit dünnschichtigem Yttrium-Eisen-Granat, die eine den ferromagnetischen Resonanzeffekt ausnutzende dünnschichtige Yttrium-Eisen-Granat-Anordnung (1) und einen Magnetkreis (2) enthält, der einen Spalt der länge 1g hat, in dem die dünnschichtige Yttrium-Eisen-Granat-Anordnung (1) angeordnet ist, und der ein Vormagnetisierungsfeld senkrecht zu einer Schichtoberfläche der dünnschichtigen Yttrium-Eisen-Granat-Anordnung (1) anlegt, wobei der Magnetkreis (2) einen Permanentmagneten (4) mit der Dicke lm und eine weichmagnetische Platte (5) mit der Dicke lx einschließt, gekennzeichnet durch den Permanentmagneten (4), der die Eigenschaften

$$Br^o > (fo/\gamma) + Nz^Y 4\pi Mso^Y$$

$$\alpha_1^B > \frac{-Nz^Y 4\pi Mso^Y}{(fo/\gamma) + Nz^Y 4\pi Mso^Y} \cdot \alpha_1^Y$$

erfüllt, und die weichmagnetische Platte (5), die die Eigenschaften

$$4\pi Mso^X < (fo/\gamma) + Nz^Y 4\pi Mso^Y$$

$$\alpha_1^X < \frac{Nz^Y 4\pi Mso^Y}{(fo/\gamma) + Nz^Y 4\pi Mso^Y} \cdot \alpha_1^Y$$

erfüllt, wobei:
fo die Resonanzfrequenz der dünnschichtigen Yttrium-Eisen-Granat-Anordnung (1) ist;
$\gamma$ das gyromagnetische Verhältnis des dünnschichtigen Yttrium-Eisen-Granats ist;
$Nz^Y$ der Entmagnetisierungsfaktor des dünnschichtigen Yttrium-Eisen-Granats ist;
$4\pi Mso^Y$ die Sättigungsmagnetisierung des dünnschichtigen Yttrium-Eisen-Granats bei Raumtemperatur ist;
$4\pi Mso^X$ die Sättigungsmagnetisierung der weichmagnetischen Platte (5) ist;
$Br^o$ die Remanenz des Permanentmagneten bei Raumtemperatur ist;
$\alpha_1^B$ der Temperaturkoeffizient erster Ordnung der Remanenz des Permanentmagneten (4) bei oder in der Nähe der Raumtemperatur ist;
$\alpha_1^Y$ der Temperaturkoeffizient erster Ordnung der Sättigungsmagnetisierung des dünnschichtigen Yttrium-Eisen-Granats bei oder in der Nähe der Raumtemperatur ist;
$\alpha_1^X$ der Temperaturkoeffizient erster Ordnung der Sättigungsmagnetisierung der weichmagnetischen Platte (5) bei oder in der Nähe der Raumtemperatur ist;
und wobei besagte Dicken lm und lx ausgewählt sind, um die Temperatureigenschaften der Resonanzfrequenz der Vorrichtung zu verbessern.

**2.** Mikrowellenvorrichtung mit dünnschichtigem Yttrium-Eisen-Granat nach Anspruch 1, in der die dünnschichtige Yttrium-Eisen-Granat-Anordnung (1) aus einem substituierten dünnschichtigen Yttrium-Eisen-Granat gebildet ist, in dem ein Teil des $Fe^{3+}$-Ionengehalts durch einen Betrag $\delta$ eines nichtmagnetischen Elements ersetzt ist, wobei der Betrag $\delta$ als eine Formeleinheit ausgedrückt wird, und in der zusätzlich zu den Dicken lm und lx der Betrag $\delta$ ausgewählt ist, um die Temperatureigenschaften der Resonanzfrequenz der Vorrichtung zu verbessern.

## Revendications

1. Appareil hyperfréquence à pellicule mince de YIG, comprenant un dispositif à pellicule mince de YIG (1) utilisant l'effet de résonance ferrimagnétique, et un circuit magnétique (2) possédant un entrefer de longueur $\ell g$ dans lequel ledit dispositif à peliicule mince de YIG (1) est placé et appliquant un champ magnétique de polarisation perpendiculaire à la surface de pellicule dudit dispositif à pellicule mince de YIG (1), ledit circuit magnéitque (2) comportant un aimant permanent (4) ayant une épaisseur $\ell m$ et une lame de matériau magnétique doux (5) ayant une épaisseur $\ell x$, caractérisé en ce que ledit aimant permanent (4) satisfait les caractéristiques :

$$Br^o > (fo/\gamma) + Nz^Y 4\pi Mso^Y$$

$$\alpha_1^B > \frac{Nz^Y 4\pi Mso^Y}{(fo/\gamma) + Nz^Y 4\pi Mso^Y} \cdot \alpha_1^Y$$

et la lame de matériau magnétique doux (5) satisfait les caractéristiques :

$$4\pi Mso^X < (fo/\gamma) + Nz^Y 4\pi Mso^Y$$

$$\alpha_1^X < \frac{Nz^Y 4\pi Mso^Y}{(fo/\gamma) + Nz^Y 4\pi Mso^Y} \cdot \alpha_1^Y$$

où :
fo est la fréquence de résonance dudit dispositif à pellicule mince de YIG (1) ;
$\gamma$ est le rapport gyromagnétique de ladite pellicule mince de YIG ;
$Nz^Y$ est le coefficient de désaimantation de ladite pellicule mince de YIG ;
$4\pi Mso^Y$ est l'aimantation à saturation de ladite pellicule mince de YIG à température ambiante ;
$4\pi Mso^X$ est l'aimantation à saturation de ladite lame de matériau magnétique doux (5) ;
$Br^o$ est la rémanence dudit aimant permanent (4) à température ambiante ;
$\alpha_1^B$ est le coefficient de température au premier ordre de la rémanence dudit aimant permanent (4) à température ambiante ou au voisinage de la température ambiante ;
$\alpha_1^Y$ est le coefficient de température au premier ordre de l'aimantation à saturation de ladite pellicule mince de YIG à la température ambiante ou au voisinage de la température ambiante ;
$\alpha_1^X$ est le coefficient de température au premier ordre de l'aimantation à saturation de ladite lame de matériau magnétique doux (5) à température ambiante ou au voisinage de la température ambiante ; et où lesdites épaisseurs $\ell m$ et $\ell x$ sont choisies de façon à permettre d'améliorer la caractéristique de température de la fréquence de résonance de l'appareil.

2. Appareil hyperfréquence à pellicule mince de YIG selon la revendication 1, où ledit dispositif à pellicule mince de YIG (1) est formé sur une pellicule mince de YIG substitué dans laquelle une partie des ions $Fe^{3+}$ est remplacée par une quantité $\delta$ d'un élément non magnétique, la quantité $\delta$ étant exprimée sous la forme d'une unité de formule, et où, en plus desdites épaisseurs $\ell m$ et $\ell x$, la quantité $\delta$ est choisie pour améliorer la caractéristique de température de la fréquence de résonance de l'appareil.

21

# FIG. I

# FIG. 2

# FIG. 3

$\ell m = 1.50mm$

$\ell x = 1.70mm$

$\ell g = 3.30mm$

# FIG. 4

# FIG. 5

# FIG. 6

# FIG. 7

# FIG.8